# EUROPEAN PATENT SPECIFICATION

(11) **EP 4 408 151 B1**
(45) Date of publication and mention of the grant of the patent: **03.12.2025**
(21) Application number: 23212355.4
(22) Date of filing: 27.11.2023
(51) Int. Cl.: H10N 69/00

(54) **QUBIT CHIP DEVICE AND METHOD OF MANUFACTURING THE SAME**
QUBIT-CHIP-VORRICHTUNG UND VERFAHREN ZUR HERSTELLUNG DAVON
DISPOSITIF DE PUCE À BITS QUANTIQUES ET SON PROCÉDÉ DE FABRICATION

(30) Priority: 27.01.2023 KR 20230011219
(43) Date of publication of application: 31.07.2024
(73) Proprietor: Samsung Electronics Co., Ltd., Suwon-si, Gyeonggi-do 16677 (KR)
(72) Inventor: LEE, Jaehyeong, Suwon-si, Gyeonggi-do 16678 (KR); KANG, Jinhyoun, Suwon-si, Gyeonggi-do 16678 (KR); JEON, Insu, Suwon-si, Gyeonggi-do 16678 (KR); SHIN, Jaeho, Suwon-si, Gyeonggi-do 16678 (KR)
(74) Representative: Grünecker Patent- und Rechtsanwälte PartG mbB

(56) References cited:
- US-A1- 2019 305 037
- US-A1- 2019 305 038
- US-A1- 2022 293 844

## Description

### BACKGROUND

### 1. Field

The disclosure relates to a qubit chip device and a method of manufacturing the qubit chip device.

### 2. Description of Related Art

A quantum computer uses quantum mechanical phenomena such as quantum superposition and quantum entanglement as operating principles to perform data processing. A unit element capable of storing information using quantum mechanical principles (or information itself) is referred to as a quantum bit or qubit, which may be used as a basic unit of information in a quantum computer.

As interest in quantum computers has increased, research has been conducted into various types of qubits. Qubits may be implemented in various types such as photon qubits, ion trap qubits, topological qubits, and superconducting qubits.

Qubits using superconductors (that is, superconducting qubits) have merits in that manufacturing superconducting qubits as integrated circuits is relatively easy. A qubit chip device of a superconducting qubit type includes a Josephson junction element and various RF circuits. These circuits include various resonators that are based on a coplanar waveguide (CPW). In this structure, a slot mode of the CPW may occur, and also, crosstalk may occur between resonance modes.
US 2019/0305037 A1 and US 2019/0305038 A1 disclose interconnects for use in superconducting quantum circuits and methods of fabricating such interconnects. US 2022/02393844 A1 relates to quantum devices and circuits, and methods of operation that facilitate reducing surface losses for quantum devices.

### SUMMARY

Provided is a qubit chip device and a method of manufacturing the qubit chip device.

Additional aspects will be set forth in part in the description which follows and, in part, will be apparent from the description, or may be learned by practice of the presented embodiments of the disclosure. According to an aspect of the disclosure, a qubit chip device according to claim 1 includes: a substrate; a superconducting qubit on the substrate; and a readout circuit on the substrate and electrically connected to the superconducting qubit, the readout circuit including: a signal line on a surface of the substrate; a ground plate on the surface of the substrate, the ground plate including a pattern forming a coplanar waveguide along the signal line and offset from the signal line; and a conductive bridge embedded in the substrate and connecting two portions of the ground plate in a direction crossing the signal line, wherein the signal line, the ground plate and the conductive bridge each comprise a same superconductive material.

The conductive bridge and the ground plate may electrically contact each other.

The conductive bridge may include NbN, NbTiN, TiN, or VN.

The conductive bridge and the ground plate may be electrically connected with each other through an ohmic contact layer.

The conductive bridge may include Al, Nb, Pb, α-Ta, or V.

The ohmic layer may contact the conductive bridge and the ground plate.

The superconducting qubit may include: a first conductive pad and a second conductive pad that are apart from each other on the surface of the substrate; and a Josephson junction element between the first conductive pad and the second conductive pad.

The first conductive pad, and the second conductive pad may each include the same superconducting material as the signal line, the ground plate and the conductive bridge.

In another general aspect, a method of manufacturing a qubit chip device according to claim 7 includes: forming a conductive bridge having two end portions exposed at a surface of a substrate and a remaining portion embedded in the substrate; forming a coplanar waveguide on the surface of the substrate such that both the end portions of the conductive bridge are in contact with a ground plate in the coplanar waveguide; and forming a Josephson junction element to be electrically connected with the coplanar waveguide, wherein the coplanar waveguide and the conductive bridge each comprise a same superconducting material.

The forming of the coplanar waveguide may be performed such that the ground plate is capable of making direct electrical contact with both end portions of the conductive bridge.

The conductive bridge may include NbN, NbTiN, TiN, or VN.

The forming of the coplanar waveguide may be performed such that the ground plate is electrically connectable, via an ohmic layer, to both the end portions of the conductive bridge.

The forming of the coplanar waveguide may include removing oxide from surfaces of both the end portions of the conductive bridge.

The conductive bridge may include Al, Nb, Pb, α-Ta, or V.

The forming of the conductive bridge may include: forming a trench by etching the substrate; depositing a superconducting material layer in the trench; forming a groove in the superconducting material layer by etching the superconducting material layer; and forming a dielectric layer in the groove.

The forming of the coplanar waveguide may include forming conductive pads connected to both sides of the Josephson junction element.

In another general aspect, a planar qubit device comprises: a superconducting qubit comprising a Josephson junction electrically connected with a signal line; a ground plate around the signal line without contacting the signal around the qubit without contacting the qubit; and a bridge under crossing under signal line and electrically connecting a first portion of the ground plate with a second portion of the ground plate, wherein the first and second portions are across from each relative to the signal line.

The signal line may comprise a waveguide configured to guide a wave read from the qubit, and wherein the signal line is connected with the qubit by an antenna pad between the signal line and the Josephson junction.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 illustrates structure of a qubit chip device according to one or more embodiments;
FIG. 2 illustrates an example of a circuit equivalent (approximation) of the qubit chip device shown in FIG. 1;
FIG. 3A is an enlarged plan view of a portion of the qubit chip device shown in FIG. 1;
FIG. 3B is a cross-sectional view taken along line B-B' of FIG. 3A;
FIG. 4A is an enlarged plan view illustrating a portion of a qubit chip device according to another embodiment;
FIG. 4B is a cross-sectional view taken along line B-B' of FIG. 4A;
FIGS. 5A to 12 illustrates a method of manufacturing a qubit chip device according to an embodiment; and
FIG. 13A to 18B illustrate a method of manufacturing a qubit chip device according to another embodiment.

### DETAILED DESCRIPTION

The following detailed description is provided to assist the reader in gaining a comprehensive understanding of the methods, apparatuses, and/or systems described herein. However, various changes and modifications of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

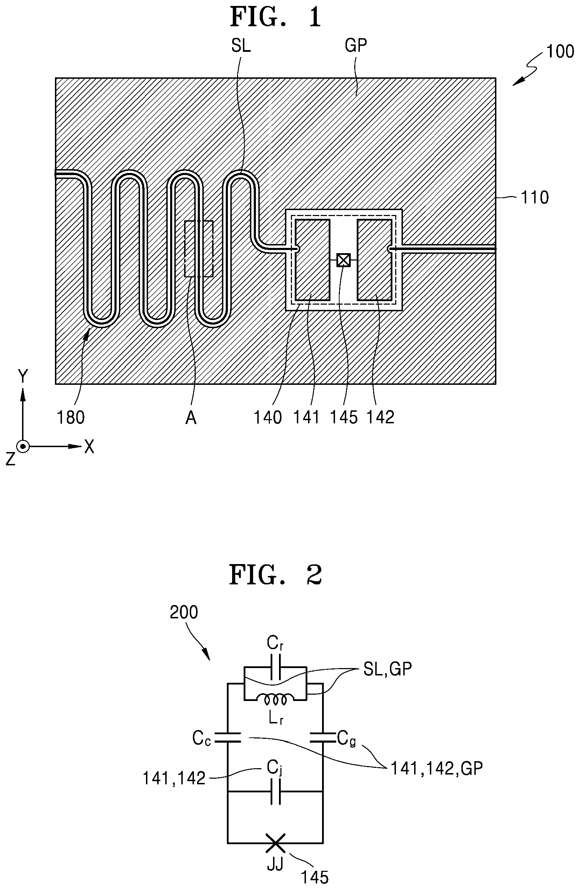

FIG. 1 illustrates structure of a qubit chip device 100 according to one or more embodiments, and FIG. 2 illustrates a circuit equivalent (approximation) of the qubit chip device 100 shown in FIG. 1.

The qubit chip device 100 includes a superconducting qubit 140 and a readout circuit 180 electrically connected to the superconducting qubit 140. The superconducting qubit 140 and the readout circuit 180 may be formed on a substrate 110. Although one superconducting qubit 140 is shown in FIG. 1, this is an example for ease of illustration. A plurality of structures such as the structure illustrated in FIG. 1 may be provided in a single substrate. For example, the plurality of structures may be arranged in a Y direction, and an end of each readout circuit 180 may be connected to an input/output line.

The substrate 110 may be a silicon substrate. Besides the silicon substrate, a silicon-on-insulator (SOI) substrate, a sapphire substrate, or an insulating substrate including various materials may be used as the substrate 110.

The superconducting qubit 140 may be, for example, a Josephson junction. The superconducting qubit 140 may be a transmon qubit. The transmon qubit may be configured to have a high ratio of Josephson energy to charging energy, which may lower the qubit's sensitivity to charge noise. The superconducting qubit 140 may include a Josephson junction element 145. The Josephson junction element 145 may include a pair of superconducting material layers (not shown) facing each other and a non-superconducting material layer (not shown) such as a dielectric layer disposed between the pair of superconducting material layers. Alternatively, the Josephson junction element 145 may include a pair of superconducting material patterns facing each other and an air gap between the pair of superconducting material patterns. Cooper pairs may tunnel Josephson junctions. Cooper pairs are electron pairs that are not subject to electrical resistance inside a superconducting material pattern. Cooper pairs exhibit the same quantum state and may be expressed by the same wave function.

The superconducting qubit 140 may include a first conductive pad 141 and a second conductive pad 142, and the Josephson junction element 145 may be disposed between the first conductive pad 141 and the second conductive pad 142. The first conductive pad 141 and the second conductive pad 142 may serve as an antenna for applying (or inducing) an electrical signal to the Josephson junction element 145 and transmitting an electrical signal emitted and received from the Josephson junction element 145. The first conductive pad 141 and the second conductive pad 142 may include a superconducting material. For example, the first conductive pad 141 and the second conductive pad 142 may include aluminum (Al), niobium (Nb), indium (In), alpha-tantalum (α-Ta), titanium (Ti), lead (Pb), vanadium (V), or a compound thereof such as NbN, NbTiN, TiN, or VN. A superconducting material layer of the Josephson junction element 145 may also include such a superconducting material.

One end of the superconducting qubit 140 may be connected to a gate electrode (not shown). For example, the second conductive pad 142 may be capacitively coupled to a connector through which a gate signal is transmitted. An energy state stored in the superconducting qubit 140 may vary according to an electrical signal applied from the gate electrode.

The other end of the superconducting qubit 140 may be connected to the readout circuit 180. For example, the first conductive pad 141 may be capacitively coupled to a signal line SL of the readout circuit 180. The energy state of the superconducting qubit 140 may be read through the reading circuit 180.

The readout circuit 180 may be implemented as a coplanar waveguide (a waveguide within a plane). As used a "coplanar" relationship refers to elements being in a same plane or in parallel planes. A coplanar waveguide forming the readout circuit 180 may include the signal line SL and a ground plate GP. The signal line SL and the ground plate GP may be formed on the same surface of the substrate 110 (additional detail is provided further below). The ground plate GP has a pattern facing the signal line SL at a distance from the signal line SL. The ground plate GP has a pattern in which a waveguide may be formed along the signal line SL, that is, along a gap (separation space) between the signal line SL and the ground plate GP, as shown in FIG. 1 and in greater detail further below.

The equivalent circuit 200 shown in FIG. 2 (a model functionally approximating the qubit device 100) may include an L-C resonant circuit (Cr and Lr in FIG. 2) and a parallel connection structure formed by a Josephson junction JJ and a capacitor Cj. A capacitor Cg and a capacitor Cc may be connected to the L-C resonant circuit. The capacitor Cj may be formed by the first conductive pad 141 and the second conductive pad 142 that are connected to the Josephson junction element 145. Parallel connection of an inductor Lr and a capacitor Cr may be formed by the signal line SL and the ground plate GP provided around the signal line SL, and the capacitor Cg and capacitor Cc may be derived from a relationship between the first conductive pad 141, the second conductive pad 142, and the ground plate GP.

The equivalent circuit 200 shown in FIG. 2 is a simplified example including one L-C resonant circuit, and the shapes of the signal line SL and the ground plate GP shown in FIG. 1 may be configured to include a plurality of L-C resonant circuits that are connected in series to each other. In this structure, a slot mode may occur due to an asymmetric coplanar waveguide, and crosstalk may occur between adjacent resonant circuits.

The readout circuit 180 of the qubit chip device 100 may include at least one conductive bridge (not shown) embedded in the substrate 110. Two portions of the ground plate GP that are adjacent to each other in a direction crossing the signal line SL may be electrically connected to each other through the at least one conductive bridge. The at least one conductive bridge may suppress the occurrence of crosstalk or a slot mode described above, or may adjust the resonance frequency of each L-C resonant circuit. A proper number of conductive bridges may be provided at proper positions according to an intended specific degree of performance. For example, several conductive bridges to several tens of conductive bridges may be provided.

In the qubit chip device 100, the signal line SL, the ground plate GP and the conductive bridge all include the same superconducting material. In addition, the first conductive pad 141, and the second conductive pad 142 may each include the same superconducting material as the signal line SL, the ground plate GP and the conductive bridge. These elements may be formed in the same process during manufacturing processes. However, embodiments are not limited thereto.

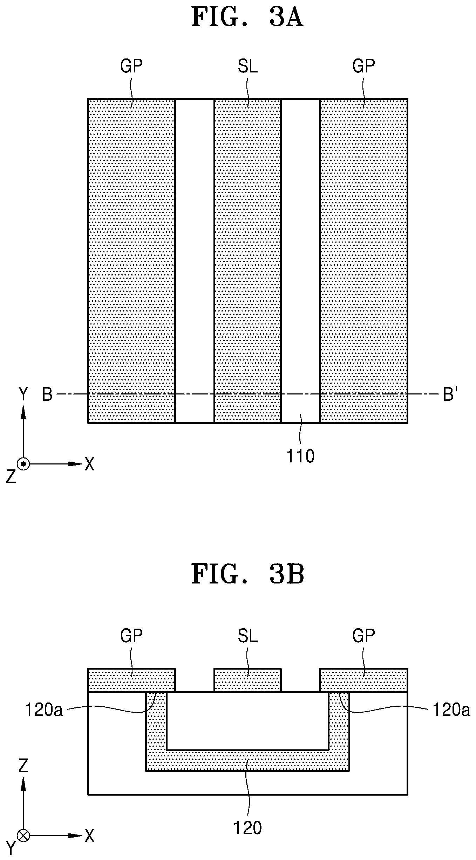

FIG. 3A is an enlarged plan view illustrating a portion of the qubit chip device 100 shown in FIG. 1 (e.g., region A), and FIG. 3B is a cross-sectional view taken along line B-B' of FIG. 3A.

A conductive bridge 120 may be embedded in the substrate 100 in a direction crossing the signal line SL, for example, in a direction crossing the signal line SL extending in a Y direction, to connect two portions of the ground plate GP to each other.

FIG. 3A illustrates an arbitrary region A on the readout circuit 180 shown in FIG. 1, and line B-B' of FIG. 3A is, for example, at an arbitrary position in the region A. The region A shown in FIG. 1 may be changed to another location on the readout circuit 180, and the conductive bridge 120 may be formed at an arbitrary location in the region shown in FIG. 3A. A various number of conductive bridges 120 may be provided at various positions under the signal line SL.

The conductive bridge 120 includes a superconducting material. The conductive bridge 120 may include, for example, aluminum (Al), niobium (Nb), indium (In), alpha-tantalum (α-Ta), titanium (Ti), lead (Pb), vanadium (V), or a compound thereof such as NbN, NbTiN, TiN, or VN.

The conductive bridge 120 and the ground plate GP may be disposed for direct electrical contact therebetween. As shown in FIG. 3B, both end portions 120a of the conductive bridge 120 may be directly in contact with portions of the ground plate GP opposite each other with respect to the signal line SL. This structure may be beneficial under manufacturing conditions where surface oxidation of the superconducting material of the conductive bridge 120 does not occur during a process of fabricating the conductive bridge 120 or when a decrease in the conductivity of the conductive bridge 120 caused by surface oxidation is small. Examples of the superconducting material may include NbN, NbTiN, TiN, or VN.

In a comparative example, a ground-ground connection may be made by wire bonding or air-bridging instead of the conductive bridge 120 of the embodiment. For example, the wire bonding may be performed by bonding an aluminum wire to both ground sides of a signal line across the signal line. The wire bonding may be performed manually using a wire bonder, generally at the very last stage of mounting a completed qubit sample on a printed circuit board (PCB), and thus there is a risk of damaging a qubit. Furthermore, in a complex structure including many qubits, the difficulty of manual work markedly increases. The air-bridging is performed by forming a dielectric-material buffer layer, patterning the dielectric-material buffer layer for allowing contact to a ground portion, and depositing a metal on the pattern to connect both ground sides except a signal line to each other. A bridge-shaped structure floating above a signal line is fabricated at a final process stage. In an etching process accompanying such a process, a film portion of a Josephson device may be damaged, or an air bridge or other structures may be damaged in an additional cleaning process. Due to these sensitive processes, there is a limit to adjusting the thickness or width of the air bridge, and thus unwanted capacitance or inductance may be added. In the case of using an air bridge, a Q-factor may indicate decrease of the performance of a qubit.

According to an embodiment, the conductive bridge 120 may be easily fabricated at an early process stage. For example, before the Josephson junction element 145, and the signal line SL and the ground plate GP constituting the coplanar waveguide are formed, the conductive bridge 120 may be embedded in the substrate 100. Therefore, damage or performance deterioration described above may not occur. In addition, with this fabrication approach, there is high freedom to adjust the thickness or width of the conductive bridge 120, for example, the thickness of the conductive bridge 120 in a Z direction or the width of the conductive bridge 120 in the Y direction. The conductive bridge 120 may have a thickness of several tens of micrometers (µm) or more. For example, the conductive bridge 120 may have a thickness of 20 µm or more, 30 µm or more, 50 µm or more, 100 µm or less, or 80 µm or less. The width of the conductive bridge 120, that is, the width of the conductive bridge 120 in a direction in which the signal line SL extends, may be freely adjusted to an intended value, such as several tens of micrometers (µm) or more, or several hundreds of micrometers (µm) or more.

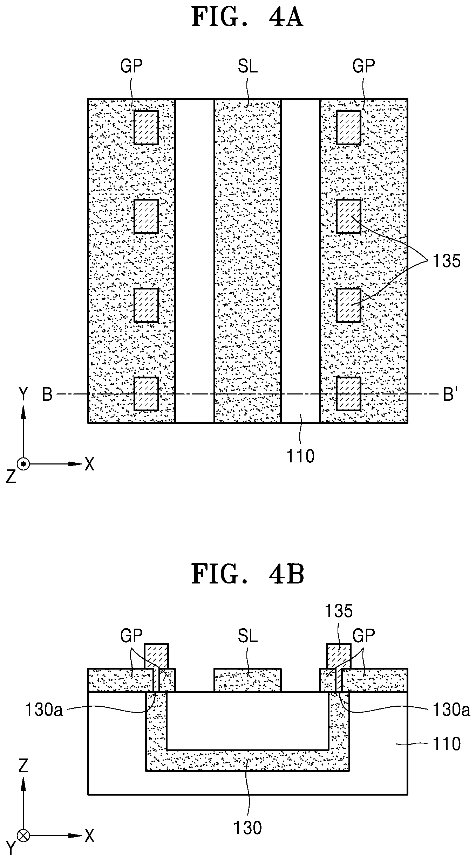

FIG. 4A is an enlarged plan view illustrating a portion of a qubit chip device according to another embodiment, and FIG. 4B is a cross-sectional view taken along line B-B' of FIG. 4A.

The device of FIGS. 4A and 4B structurally differs from the device of FIGS. 3A and 3B where both end portions 130a of each conductive bridge 130 are in contact with a ground plate GP.

The conductive bridges 130 may electrically contact the ground plate GP through an ohmic contact layer 135. Portions of the ground plate GP that adjoin the end portions 130a of the conductive bridges 130 may be patterned such that the ground plate GP may not completely cover the end portions 130a of the conductive bridges 130 but may partially expose the end portions 130a of the conductive bridges 130. That is, there may be through-holes of various shape where the end portions 130a contact the ground plate GP. The ohmic contact layer 135 covers the exposed end portions 130a of the conductive bridges 130 and extends upward from the ground plate GP, e.g., filling the through-holes.

This structure may be selected when a superconducting material included in the conductive bridges 130 easily undergoes surface oxidation during a manufacturing process. For example, the conductive bridges 130 may include Al, Nb, Pb, α-Ta, or V. Before the ground plate GP is formed, surfaces of both end portions 130a of each of the conductive bridges 130 exposed at a surface of a substrate 110 may undergo oxidation, and thus when the ground plate GP is formed on the oxidized end portions 130a of the conductive bridges 130, electrical contact between the end portions 130a of the conductive bridges 130 and the ground plate GP may be poor. Therefore, after the ground plate GP having a pattern exposing the end portions 130a of the conductive bridges 130 is formed, an additional process of removing surface oxides may be performed, and then the ohmic contact layer 135 may be formed.

The structure illustrated in FIG. 3B and the structure illustrated in FIG. 4B have been separately described depending on the superconducting material of the conductive bridge 120 and the superconducting material of the conductive bridges 130. However, embodiments are not limited to the materials and structures described above. For example, even a case of a superconducting material which can be used in the structure shown in FIG. 3B, the structure shown in FIG. 4B may be selected for more reliable electrical contact.

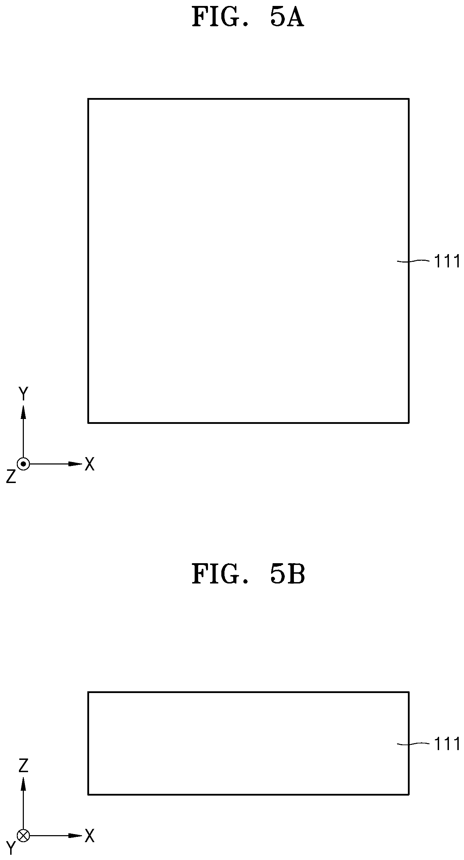

FIGS. 5A to 12 illustrate a method of manufacturing a qubit chip device according to one or more embodiments.

First, a substrate 111 is prepared as shown in FIGS. 5A and 5B. The substrate 111 may be a silicon substrate or any one of other various insulating substrates. That is, any one of substrates including various materials may be used as the substrate 111 as long as it is possible to form a coplanar waveguide, a superconducting qubit, a readout circuit, and the like on the substrate 111.

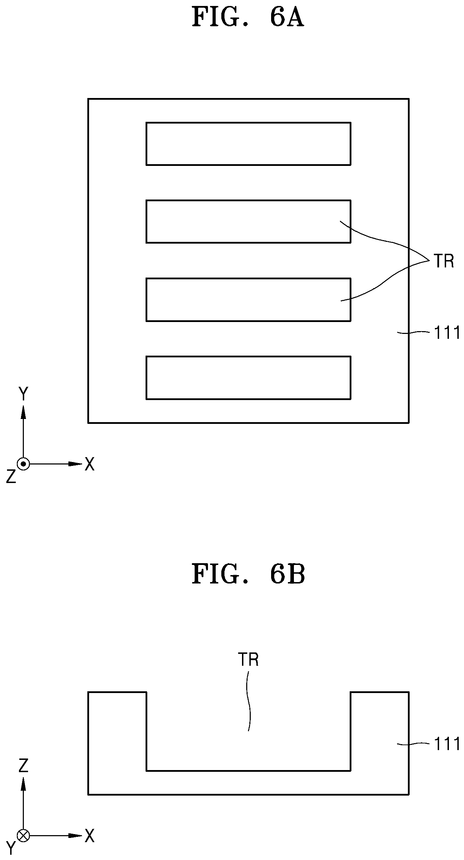

Next, as shown in FIGS. 6A and 6B, trenches TR are formed in the substrate 111. The number, interval, or size of the trenches TR illustrated in FIGS. 6A and 6B is merely an example. For example, the trenches TR may have different widths, that is, different Y-direction widths according to the positions of the trenches TR.

The trenches TR may be formed to have an intended width, length, or depth. To this end, the trenches TR may be formed through a photolithography process and an etching process. The width, length, or depth of the trenches TR may be determined by considering the width, length, or thickness of conductive bridges to be fabricated. That is, the shape of the trenches TR (from above) may correspond, in some dimensions, to the shape of the conductive bridges. The depth of the trenches TR may be several tens of micrometers (µm). The depth of the trenches TR may be approximately 100 µm or more.

After forming the trenches TR, a process of planarizing inner bottom surfaces of the trenches TR may be performed. For example, a chemical mechanical polishing (CMP) process may be performed, and then a cleaning process may be performed.

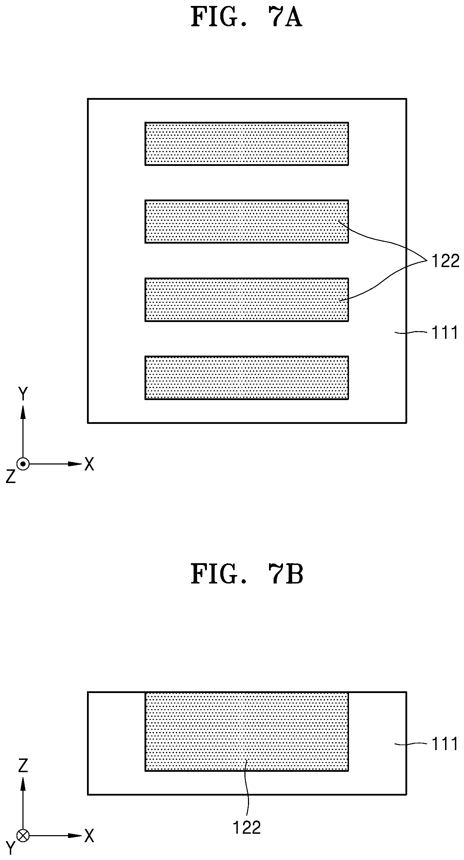

Referring to FIGS. 7A and 7B, a superconducting material layer 122 may be formed in the trenches TR. The superconducting material layer 122 may be formed by depositing a superconducting material (described above). Among the example superconducting materials listed above, a superconducting material that does not easily undergo surface oxidation may be used to form the superconducting material layer 122. As shown in FIG. 7B (cross-sectional view), the superconducting material layer 122 may be formed to a height reaching a surface of the substrate 111. However, the shape illustrated in FIGS. 7A and 7B is merely an example, and it may be sufficient that the thickness of the superconducting material layer 122 is greater than or equal to the thickness of conductive bridges to be fabricated.

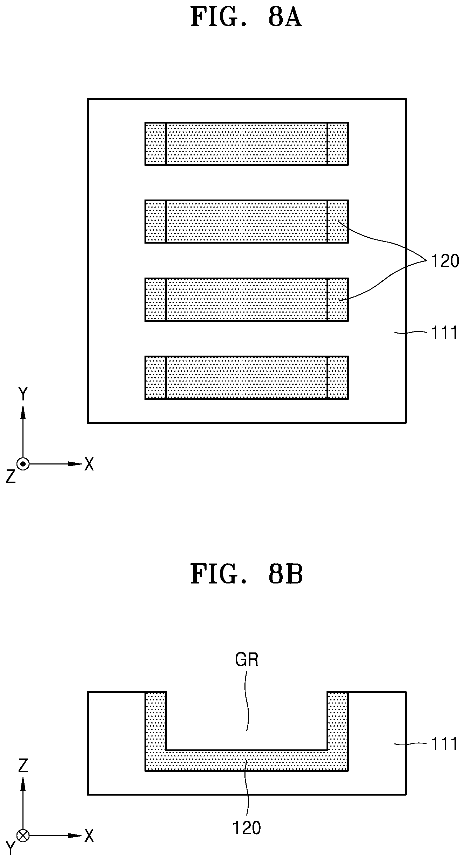

Referring to FIGS. 8A and 8B, the superconducting material layer 122 is etched to form conductive bridges 120. During the etching process, grooves GR may be formed.

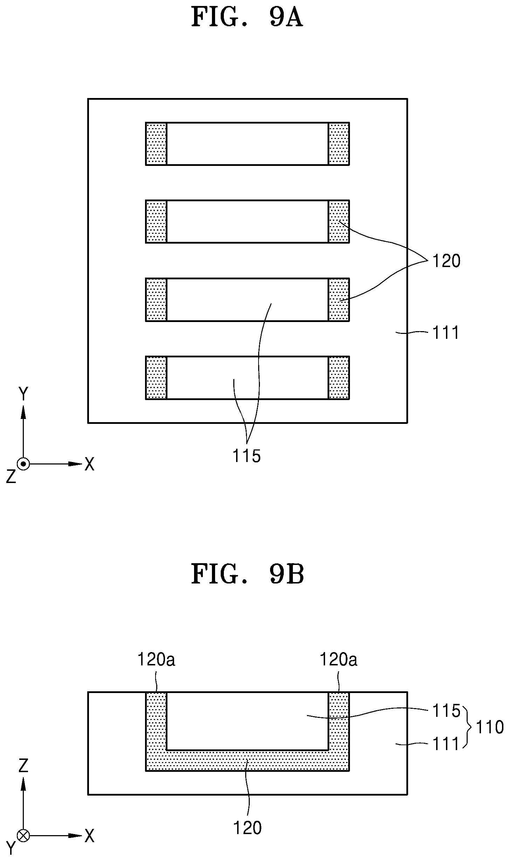

Referring to FIGS. 9A and 9B, a dielectric material layer 115 is formed in the grooves GR. After forming the dielectric material layer 115, a planarization process may be further performed to make the surface of the dielectric material layer 115 flat and parallel with the surface of the substrate 111. The combination of the dielectric material layer 115 and the substrate 111 may be referred to as a substrate 110. As a result, end portions 120a of the conductive bridges 120 may be exposed at the surface of the substrate 110, and remaining portions of the conductive bridges 120, that is, portions of the conductive bridges 120 other than the end portions 120a, may be embedded in the substrate 110.

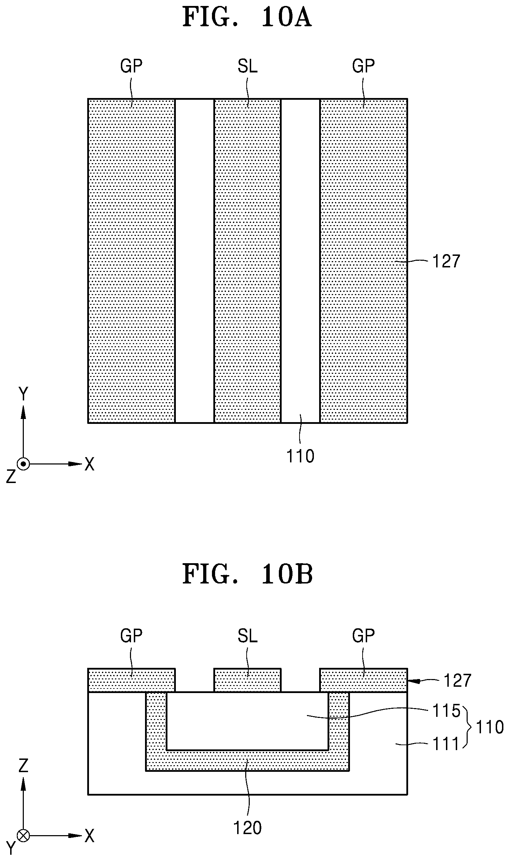

Referring to FIGS. 10A and 10B, a superconducting material layer 127 is formed on the substrate 110. The superconducting material layer 127 has a pattern forming a coplanar waveguide, that is, forming a ground plate GP and a signal line SL. A superconducting material included in the conductive bridges 120 does not easily undergo surface oxidation, that is, the surface condition of the end portions 120a of the conductive bridges 120 may be good (low oxidation), and thus the end portions 120a of the conductive bridges 120 may be reliably in electrical contact with the ground plate GP.

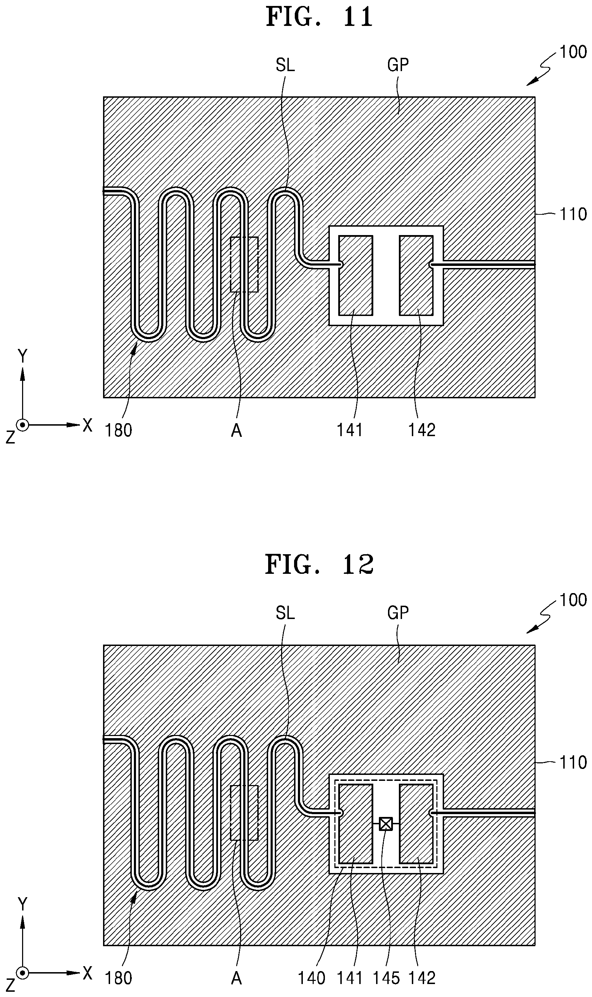

FIG. 11 shows the pattern of the superconducting material layer 127 in the process described with reference to FIGS. 10A and 10B. The pattern of the superconducting material layer 127 not only forms the ground plate GP and the signal line SL that constitute a readout circuit 180 based on a coplanar waveguide, but also first and second conductive pads 141 and 142 that constitute an antenna of a superconducting qubit.

Next, as shown in FIG. 12, after a process of fabricating a Josephson junction element 145 is performed, manufacture of a qubit chip device 100 including a superconducting qubit 140 and the readout circuit 180 may be generally completed.

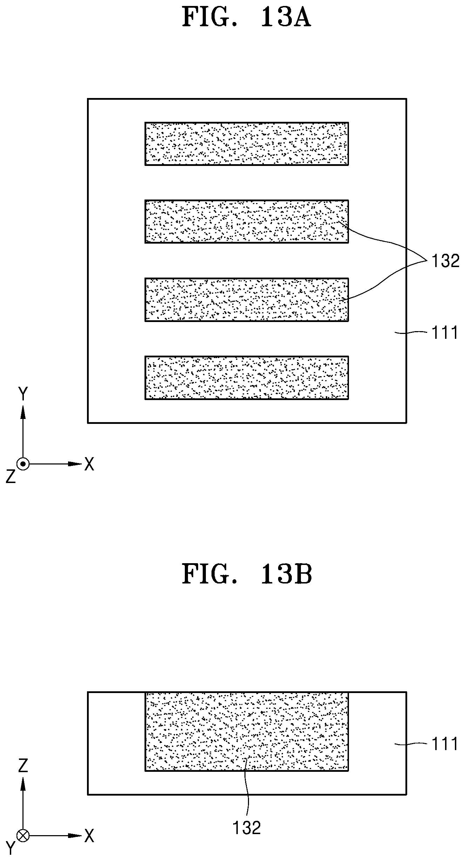

FIG. 13A to 18B are views illustrating a method of manufacturing a qubit chip device according to another embodiment.

The manufacturing method of the current embodiment is for the case of having a different contact structure between conductive bridges and a ground plate, depending on a superconducting material included in the conductive bridges. Differences from the manufacturing method described with reference to FIGS. 5A to 12 will be mainly described.

Referring to FIGS. 13A and 13B, a superconducting material layer 132 is formed in trenches TR that are formed as described with reference to FIGS. 6A and 6B.

The superconducting material layer 132 may include aluminum. The superconducting material layer 132 may include a superconducting material other than aluminum, for example, a superconducting material that easily undergoes surface oxidation.

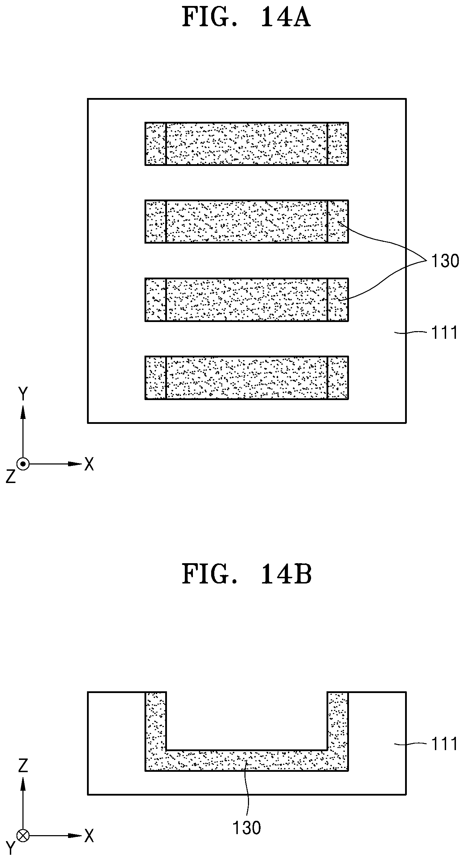

Referring to FIGS. 14A and 14B, the superconducting material layer 132 may be etched to have an intended thickness, thereby forming conductive bridges 130.

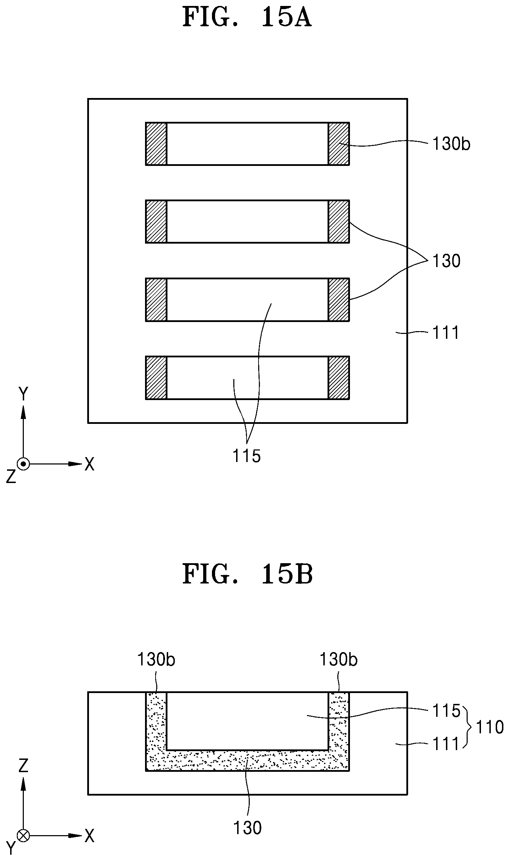

Referring to FIGS. 15A and 15B, a dielectric material layer 115 is formed on the conductive bridges 130. The dielectric material layer 115 may be planarized to be parallel with a surface of a substrate 111. The dielectric material layer 115 and the substrate 111 may be collectively referred to as a substrate 110.

In this process, exposed end portions 130b of the conductive bridges 130 may be oxidized. In other words, the conductivity of the end portions 130b may be different from the conductivity of the other portions of the conductive bridges 130 formed by another process, and thus an additional process for forming ohmic contacts may be performed.

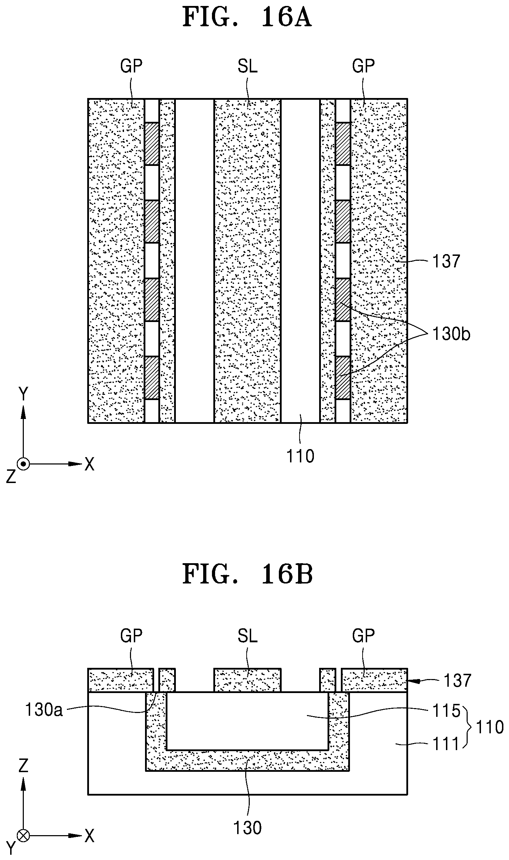

Referring to FIGS. 16A and 16B, a superconducting material layer 137 is formed on the substrate 110. The superconducting material layer 137 is applied with a pattern forming a signal line SL and a ground plate GP. In addition, the pattern has windows WW through which the end portions 130b of the conductive bridges 130 are partially exposed. Portions of the pattern of the superconducting material layer 137 other than the windows WW may include, for example, the signal line SL, the ground plate GP, and first and second conductive pads 141 and 142 as illustrated FIG. 11. Next, a process of removing oxides from the end portions 130b of the conductive bridges 130 through the windows WW may be performed. For example, an argon (Ar) milling process may be used.

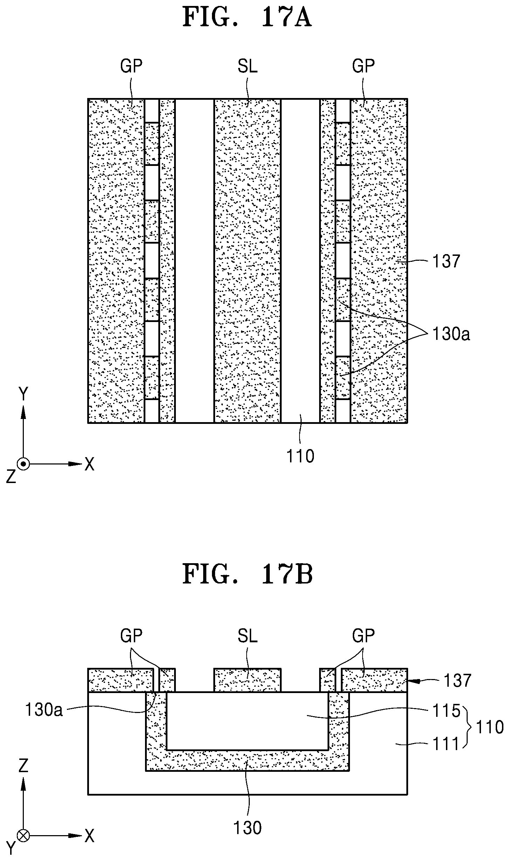

FIGS. 17A and 17B illustrate the end portions 130a of the conductive bridges 130 after oxides are removed from the end portions 130a.

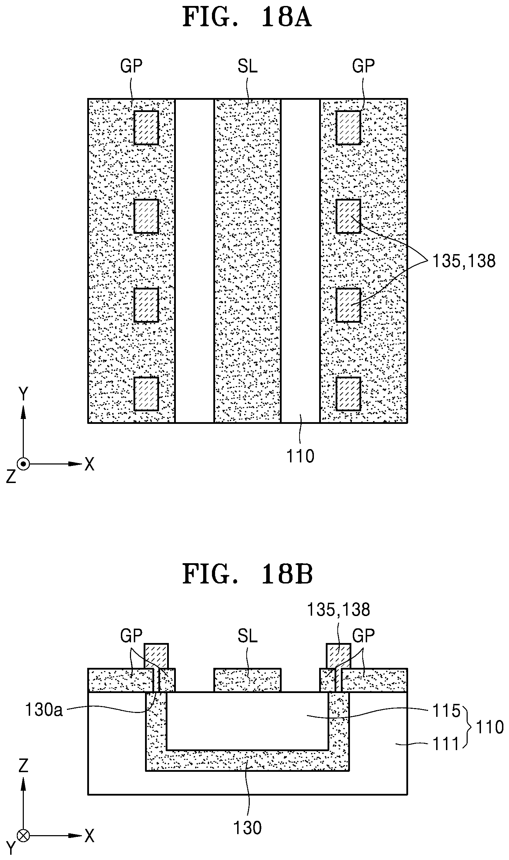

Next, referring to FIGS. 18A and 18B, an ohmic contact layer 138 is formed through the windows WW such that the ohmic contact layer 138 may be in contact with the end portions 130a of the conductive bridges 130 and may extend upward from the ground plate GP. The ohmic contact layer 138 and the ground plate GP may include the same superconducting material, but are not limited thereto. As described above, the conductive bridges 130 and the ground plate GP may be electrically in contact with each other through the ohmic contact layer 138.

In addition, the shape in which the ohmic contact layer 138 is in contact with the ground plate GP may be the same as that shown in FIG. 4A or may be modified according to the specific shape of the windows WW through which the end portions 130a of the conductive bridges 130 are exposed.

As described above, according to the one or more of the above embodiments, the qubit chip device includes conductive bridges embedded in a substrate, and the conductive bridges may have a high degree of shape design freedom. Thus, the qubit chip device may have high performance.

According to the methods of manufacturing a qubit chip device, conductive bridges may be fabricated before a Josephson junction element or a coplanar waveguide is fabricated. Thus, the conductive bridges may be easily formed in an intended shape without damaging the qubit chip device.

While qubit chip devices and methods of manufacturing the qubit chip devices have been described according to embodiments with reference to the accompanying drawings, it will be understood by those of ordinary skill in the art that the qubit chip devices and methods of manufacturing the qubit chip devices are merely examples, and various modifications may be made therein. Therefore, the embodiments described herein should be considered in a descriptive sense only and not for purposes of limitation. The invention is defined not by the above description but by the following claims.

## Claims

1. A qubit chip device (100) comprising:
a substrate (110);
a superconducting qubit (140) on the substrate (110); and
a readout circuit (180) on the substrate (110) and electrically connected to the superconducting qubit (140), the readout circuit (180) comprising:
a signal line (SL) on a surface of the substrate (110);
a ground plate (GP) on the surface of the substrate (110), the ground plate (GP) comprising a pattern forming a coplanar waveguide along the signal line (SL) and offset from the signal line (SL); and
a conductive bridge (120; 130) embedded in the substrate (110) and connecting two portions of the ground plate (GP) in a direction crossing the signal line (SL),
**characterized in that** the signal line (SL), the ground plate (GP) and the conductive bridge (120; 130) each comprise a same superconducting material.

2. The qubit chip device (100) of claim 1, wherein the conductive bridge (120; 130) and the ground plate (GP) electrically contact with each other,
in particular,
wherein the conductive bridge (120) comprises NbN, NbTiN, TiN or VN.

3. The qubit chip device (100) of claim 1 or 2, wherein the conductive bridge (130) and the ground plate (GP) are electrically connected with each other through a contact layer (135).

4. The qubit chip device (100) of claim 3, wherein the conductive bridge (130) comprises Al, Nb, Pb, α-Ta, or V, and/or
wherein the contact layer (135) contacts the conductive bridge (130) and the ground plate (GP).

5. The qubit chip device (100) of any of the preceding claims, wherein the superconducting qubit comprises (140):
a first conductive pad (141) and a second conductive pad (142) that are apart from each other on the surface of the substrate (110); and
a Josephson junction element (145) between the first conductive pad (141) and the second conductive pad (142).

6. The qubit chip device (100) of claim 5, wherein the first conductive pad (141), and the second conductive pad (142) each comprise the same superconducting material as the signal line (SL), the ground plate (GP) and the superconducting bridge (120; 130).

7. A method of manufacturing a qubit chip device (100), the method comprising:
forming a conductive bridge (120; 130) having two end portions (120a; 130a) exposed at a surface of a substrate (110) and a remaining portion embedded in the substrate (110);
forming a coplanar waveguide on the surface of the substrate (110) such that both the end portions (120a; 130a) of the conductive bridge (120; 130) are in contact with a ground plate (GP) in the coplanar waveguide; and
forming a Josephson junction (145) element to be electrically connected with the coplanar waveguide,
**characterized in that** the coplanar waveguide and the conductive bridge (120; 130) each comprise a same superconducting material.

8. The method of claim 7, wherein the forming of the coplanar waveguide is performed such that the ground plate (GP) is capable of making direct electrical contact with both end portions (120a; 130a) of the conductive bridge (120; 130).

9. The method of claim 8, wherein the conductive bridge (120; 130) comprises NbN, NbTiN, TiN, or VN.

10. The method of claim 7, wherein the forming of the coplanar waveguide is performed such that the ground plate (GP) is electrically connectable, via a layer (135; 138), to both the end portions (120a; 130a) of the conductive bridge (120; 130).

11. The method of claim 10, wherein the forming of the coplanar waveguide comprises removing oxide from surfaces of both the end portions (120a; 130a) of the conductive bridge (120; 130), and/or
wherein the conductive bridge (120; 130) comprises Al, Nb, Pb, α-Ta, or V.

12. The method of any of claims 7 to 11, wherein the forming of the conductive bridge (120; 130) comprises:
forming a trench (TR) by etching the substrate (110);
depositing a superconducting material layer (122) in the trench (TR);
forming a groove (GR) in the superconducting material layer (122) by etching the superconducting material layer (122); and
forming a dielectric material layer (115) in the groove (GR).

13. The method of any of claims 7 to 12, wherein the forming of the coplanar waveguide comprises forming conductive pads (141, 142) connected to both sides of the Josephson junction element (145).

## Patentansprüche

1. Eine Qubit-Chip-Vorrichtung (100) weist auf:
ein Substrat (110);
ein supraleitendes Qubit (140) auf dem Substrat (110); und
eine Ausleseschaltung (180) auf dem Substrat (110), die elektrisch mit dem supraleitenden Qubit (140) verbunden ist, wobei die Ausleseschaltung (180) Folgendes aufweist:
eine Signalleitung (SL) auf einer Oberfläche des Substrats (110);
eine Grundplatte (GP) auf der Oberfläche des Substrats (110), wobei die Grundplatte (GP) ein Muster aufweist, das einen koplanaren Wellenleiter entlang der Signalleitung (SL) und versetzt von der Signalleitung (SL) bildet; und
eine leitende Brücke (120; 130), die in das Substrat (110) eingebettet ist und zwei Abschnitte der Grundplatte (GP) in einer die Signalleitung (SL) kreuzenden Richtung verbindet,
**dadurch gekennzeichnet, dass** die Signalleitung (SL), die Grundplatte (GP) und die leitende Brücke (120; 130) jeweils dasselbe supraleitende Material aufweisen.

2. Die Qubit-Chip-Vorrichtung (100) nach Anspruch 1, wobei die leitende Brücke (120; 130) und die Grundplatte (GP) elektrisch miteinander in Kontakt stehen,
insbesondere,
wobei die leitende Brücke (120) NbN, NbTiN, TiN oder VN aufweist.

3. Die Qubit-Chip-Vorrichtung (100) nach Anspruch 1 oder 2, wobei die leitende Brücke (130) und die Grundplatte (GP) über eine Kontaktschicht (135) elektrisch miteinander verbunden sind.

4. Die Qubit-Chip-Vorrichtung (100) nach Anspruch 3, wobei die leitende Brücke (130) Al, Nb, Pb, α-Ta oder V aufweist, und/oder
wobei die Kontaktschicht (135) die leitende Brücke (130) und die Grundplatte (GP) kontaktiert.

5. Die Qubit-Chip-Vorrichtung (100) nach einem der vorhergehenden Ansprüche, wobei das supraleitende Qubit aufweist (140):
ein erstes leitendes Pad (141) und ein zweites leitendes Pad (142), die auf der Oberfläche des Substrats (110) voneinander beabstandet sind; und
ein Josephson-Übergangselement (145) zwischen dem ersten leitenden Pad (141) und dem zweiten leitenden Pad (142).

6. Die Qubit-Chip-Vorrichtung (100) nach Anspruch 5, wobei das erste leitende Pad (141) und das zweite leitende Pad (142) jeweils dasselbe supraleitende Material aufweisen wie die Signalleitung (SL), die Grundplatte (GP) und die supraleitende Brücke (120; 130).

7. Ein Verfahren zur Herstellung einer Qubit-Chip-Vorrichtung (100), wobei das Verfahren aufweist:
Ausbilden einer leitenden Brücke (120; 130) mit zwei Endabschnitten (120a; 130a), die an einer Oberfläche eines Substrats (110) freiliegen, und einem restlichen Abschnitt, der in das Substrat (110) eingebettet ist;
Bilden eines koplanaren Wellenleiters auf der Oberfläche des Substrats (110), so dass beide Endabschnitte (120a; 130a) der leitenden Brücke (120; 130) in Kontakt mit einer Masseplatte (GP) in dem koplanaren Wellenleiter sind; und
Ausbilden eines Josephson-Übergangselements (145), das elektrisch mit dem koplanaren Wellenleiter verbunden wird,
**dadurch gekennzeichnet, dass** der koplanare Wellenleiter und die leitende Brücke (120; 130) jeweils ein und dasselbe supraleitende Material aufweisen.

8. Das Verfahren nach Anspruch 7, wobei das Ausbilden des koplanaren Wellenleiters so durchgeführt wird, dass die Grundplatte (GP) in der Lage ist, direkten elektrischen Kontakt mit beiden Endabschnitten (120a; 130a) der leitenden Brücke (120; 130) herzustellen.

9. Das Verfahren nach Anspruch 8, wobei die leitende Brücke (120; 130) NbN, NbTiN, TiN oder VN aufweist.

10. Das Verfahren nach Anspruch 7, wobei das Bilden des koplanaren Wellenleiters so durchgeführt wird, dass die Grundplatte (GP) über eine Schicht (135; 138) mit beiden Endabschnitten (120a; 130a) der leitenden Brücke (120; 130) elektrisch verbindbar ist.

11. Das Verfahren nach Anspruch 10, wobei das Bilden des koplanaren Wellenleiters das Entfernen von Oxid von den Oberflächen der beiden Endabschnitte (120a; 130a) der leitenden Brücke (120; 130) aufweist, und/oder
wobei die leitende Brücke (120; 130) Al, Nb, Pb, α-Ta oder V aufweist.

12. Das Verfahren nach einem der Ansprüche 7 bis 11, wobei das Ausbilden der leitenden Brücke (120; 130) aufweist:
Ausbilden eines Grabens (TR) durch Ätzen des Substrats (110);
Abscheiden einer Schicht aus supraleitendem Material (122) in dem Graben (TR);
Bilden einer Nut (GR) in der supraleitenden Materialschicht (122) durch Ätzen der supraleitenden Materialschicht (122); und
Bilden einer dielektrischen Materialschicht (115) in der Nut (GR).

13. Das Verfahren nach einem der Ansprüche 7 bis 12, wobei das Ausbilden des koplanaren Wellenleiters das Ausbilden leitender Pads (141, 142) aufweist, die mit beiden Seiten des Josephson-Übergangselements (145) verbunden sind.

## Revendications

1. Dispositif de puce à bits quantiques (qubit) (100) comprenant :
un substrat (110) ;
un qubit supraconducteur (140) sur le substrat (110) ; et
un circuit de lecture (180) sur le substrat (110) et électriquement connecté au qubit supraconducteur (140), le circuit de lecture (180) comprenant :
une ligne de signal (SL) sur une surface du substrat (110) ;
une plaque de masse (GP) sur la surface du substrat (110), la plaque de masse (GP) comprenant un motif formant un guide d'onde coplanaire le long de la ligne de signal (SL) et décalé par rapport à la ligne de signal (SL) ; et
un pont conducteur (120 ; 130) incorporé dans le substrat (110) et connectant deux parties de la plaque de masse (GP) dans une direction coupant la ligne de signal (SL),
**caractérisé en ce que**
la ligne de signal (SL), la plaque de masse (GP) et le pont conducteur (120 ; 130) comprennent chacun un même matériau supraconducteur.

2. Le dispositif de puce à bits quantiques (100) de la revendication 1, dans lequel le pont conducteur (120 ; 130) et la plaque de masse (GP) sont électriquement en contact l'un avec l'autre,
en particulier,
dans lequel le pont conducteur (120) comprend du NbN, NbTiN, TiN ou VN.

3. Le dispositif de puce à bits quantiques (100) de la revendication 1 ou 2, dans lequel le pont conducteur (130) et la plaque de masse (GP) sont électriquement en contact l'un avec l'autre à travers une couche de contact (135).

4. Le dispositif de puce à bits quantiques (100) de la revendication 3, dans lequel le pont conducteur (130) comprend du Al, Nb, Pb, α-Ta ou V, et/ou
dans lequel la couche de contact (135) est en contact avec le pont conducteur (130) et la plaque de masse (GP).

5. Le dispositif de puce à bits quantiques (100) de l'une quelconque des revendications précédentes, dans lequel le qubit supraconducteur comprend (140) :
un premier support conducteur (141) et un deuxième support conducteur (142) qui sont séparés l'un de l'autre sur la surface du substrat (110) ; et
un élément de jonction Josephson (145) entre le premier support conducteur (141) et le deuxième support conducteur (142).

6. Le dispositif de puce à bits quantiques (100) de la revendication 5, dans lequel le premier support conducteur (141) et le deuxième support conducteur (142) comprennent chacun le même matériau supraconducteur en tant que la ligne de signal (SL) la plaque de masse (GP) et le pont supraconducteur (120 ; 130).

7. Procédé de fabrication d'un dispositif de puce à bits quantiques (100), le procédé comprenant :
une formation d'un pont conducteur (120 ; 130) présentant deux parties d'extrémité (120a ; 130a) exposées à une surface d'un substrat (110) et une partie restante incorporée dans le substrat (110) ;
une formation d'un guide d'onde coplanaire sur la surface du substrat (110) de sorte que les deux parties d'extrémité (120a ; 130a) du pont conducteur (120 ; 130) soient en contact avec une plaque de masse (GP) dans le guide d'onde coplanaire ; et
une formation d'un élément de jonction Josephson (145) à connecter électriquement au guide d'onde coplanaire,
**caractérisé en ce que**
le guide d'onde coplanaire et le pont conducteur (120 ; 130) comprennent chacun un même matériau supraconducteur.

8. Le procédé de la revendication 7, dans lequel la formation du guide d'onde coplanaire est effectuée de sorte que la plaque de masse (GP) soit en mesure d'établir un contact électrique direct avec les deux parties d'extrémité (120a ; 130a) du pont conducteur (120 ; 130).

9. Le procédé de la revendication 8, dans lequel le pont conducteur (120 ; 130) comprend
NbN, NbTiN, TiN ou VN.

10. Le procédé de la revendication 7, dans lequel la formation du guide d'onde coplanaire est effectuée de sorte que la plaque de masse (GP) soit électriquement raccordable, via une couche (135 ; 138), aux deux parties d'extrémité (120a ; 130a) du pont conducteur (120 ; 130).

11. Le procédé de la revendication 10, dans lequel la formation du guide d'onde coplanaire comprend une élimination d'oxyde de surfaces des deux parties d'extrémité (120a ; 130a) du pont conducteur (120 ; 130), et/ou
dans lequel le pont conducteur (120 ; 130) comprend du Al, Nb, Pb, α-Ta ou V.

12. Le procédé de l'une quelconque des revendications 7 à 11, dans lequel la formation du pont conducteur (120 ; 130) comprend :
une formation d'une tranchée (TR) en gravant le substrat (110) ;
un dépôt d'une couche de matériau supraconducteur (122) dans la tranchée (TR) ;
une formation d'une rainure (GR) dans la couche de matériau supraconducteur (122) en gravant la couche de matériau supraconducteur (122) ; et
une formation d'une couche de matériau diélectrique (115) dans la rainure (GR).

13. Le procédé de l'une quelconque des revendications 7 à 12, dans lequel la formation du guide d'onde coplanaire comprend une formation de supports conducteurs (141, 142) connectés aux deux côtés de l'élément de jonction Josephson (145).
